# EUROPEAN PATENT APPLICATION

(11) **EP 4 353 542 A1**
(43) Date of publication of application: **17.04.2024**
(21) Application number: 23202939.7
(22) Date of filing: 11.10.2023
(51) Int. Cl.: B60R 16/02, H01B 13/012

(54) **ELECTRONIC CONTROL UNIT AND ELECTRICAL CONNECTION SYSTEM**

(30) Priority: 11.10.2022 US 202263415156 P; 09.10.2023 US 202318377937
(71) Applicant: Aptiv Technologies AG, 8200 Schaffhausen (CH)
(72) Inventor: REIDER, Christopher, Canfield, OH 44406 (US); CAMPBELL, Jeffrey S., West Bloomfield, MI 48324 (US); WEBER, Wesley W., Metamora, MI 48455 (US); URBANIAK, Andreas, 48153 Münster (DE); FRUEND, Marcel, 42859 Remscheid (DE); SEIFERT, Kurt P., Cortland, OH 44410 (US); SOHN, Marc, 71139 Ehningen (DE)
(74) Representative: Bardehle Pagenberg Partnerschaft mbB Patentanwälte Rechtsanwälte

(57) **Abstract**

Systems, methods, and devices providing for the robotic installation of vehicle electrical systems are described. A vehicle wiring harness includes first and second cables, a robotic gripping arm, and at least two pairs of stiffeners coupled to the cables to define folding points and corresponding segments that enable robotic folding and unfolding of the wiring harness. In other examples, a wiring harness is coupled to a plurality of electrical connectors carried by a carrier plate of an electrical control unit connection system (ECU), which is installed by robotically mating the plurality of electrical connectors carried by the carrier plate.

## Description

### PRIORITY

This application is a non-provisional application that claims priority to provisional application 63/415,156 titled "ELECTRONIC CONTROL UNIT AND ELECTRICAL CONNECTION SYSTEM" filed October 11, 2022, the entire contents of which are incorporated herein by reference.

### BACKGROUND

Wiring harnesses are commonly used to support interconnection of distributed electrical system(s) and/or components in vehicular applications. A wiring harness may include cabling that distributes signal, power, and/or data signals to different physical locations within a vehicle via connectors coupled to the wiring harness. In many applications, manual effort is required to pack and unpack a wiring harness, arrange the harness in a desired position in the vehicle, and couple connectors to establish electrical connections between the wiring harness and other components and/or systems associated with the vehicle. A need therefore exists for improvements that reduce the amount of manual effort needed to install electrical systems as part of vehicle manufacturing processes.

### SUMMARY

This application is directed to vehicle electrical systems, and more particularly, wiring harnesses and electrical connector systems associated with wiring harnesses that are adapted to minimize manual effort needed to install a vehicle electrical system. The various examples of wiring harnesses and electrical connection systems described are adapted to be particularly suited to robotic installation, representing a significant improvement over known vehicle electrical systems.

According to one example, a wiring harness of a vehicle is described. The wiring harness includes a first cable and a second cable that each carry electrical conductors in the form of wiring. The wiring harness further includes a plurality of stiffeners that define one or more folding points of the wiring harness. The wiring harness further includes a rigid gripping member mechanically coupled between the first and second cables to define a distance, wherein the rigid gripping member is configured to be grabbable by a robotic arm, and manipulated to fold and unfold the wiring harness at the folding points defined by the plurality of stiffeners.

According to another example, a method is described. The method includes gripping, with a robotic actuator, a wiring harness by a rigid gripping member coupled between a first cable and a second cable of a wiring harness. In some examples, the robotic actuator has a length that corresponds to a distance between the first and second cable in an installation position of the wiring harness in a vehicle. The method further includes, in a first motion of the robotic actuator, unfolding a first segment of the wiring harness by causing the first segment to unfold from a second segment at a first folding point defined by a first pair of stiffeners coupled to the first and second cables. In some examples, causing the first segment to unfold from the second segment includes rotating the wiring harness via the rigid gripping member to cause the first segment to unfold from the second segment. The method further includes, in a second motion of the robotic actuator, unfolding the second segment of the wiring harness by causing the second segment to unfold from a third segment of the wiring harness at a second folding point defined by a second pair of stiffeners coupled to the first and second cables. In some examples, the second motion further includes placing the wiring harness in a desired installation position within a vehicle.

According to another example, an electronic control unit (ECU) is described. The ECU includes a main body mountable at a position within the vehicle and having a plurality of first connector portions. The ECU further includes a carrier plate that carries a plurality of second connector portions that correspond to the plurality of first connector portions. The carrier plate is configured such that the plurality of first and second connector portions are brought into staged alignment when the carrier plate is coupled to the main body. The ECU is installed in the vehicle by pushing the pluralities of first and second connector portions together to form a plurality of electrical connectors of the ECU.

According to another example, a method is described. The method includes mounting a main body of an ECU within a vehicle, wherein the main body has a plurality of first connector portions. The method further includes positioning a carrier plate carrying a plurality of second connector portions in alignment with the main body. The method further includes securing the carrier plate to the main body, thereby bringing the first and second connector portions into staged alignment to be mated together through the carrier plate. In some examples, the method further includes sequentially mating each of the plurality of first and second connector portions to form a plurality of electrical connectors of the ECU. In other examples, the method further includes mating the plurality of first and second electrical connector portions simultaneously by securing the carrier plate to the main body.

### BRIEF DESCRIPTION OF THE DRAWINGS

The present invention will now be described, by way of example with reference to the accompanying drawings, in which:
FIG. 1 shows one example of a wiring harness in an unfolded position according to some embodiments.
FIG. 2 shows an unfolded wiring harness being grabbed by a robotic actuator according to some embodiments.
FIG. 3 shows a wiring harness in a folded position according to some embodiments.
FIG. 4 shows a wiring harness being unfolded by a robotic actuator according to some embodiments.
FIG. 5 shows a wiring harness unfolded in an installation position in a vehicle according to some embodiments.
FIG. 6 is a flow diagram showing one example of a method of robotically installing a wiring harness according to some embodiments.
FIG. 7A shows one example of an electronic control unit (ECU) according to some embodiments.
FIG. 7B shows an exploded view of one example of an electronic control unit (ECU) according to some embodiments.
FIG. 8 shows one example of an electrical connector according to some embodiments.
FIG. 9 shows an exploded view of an electrical connector according to some embodiments.
FIG. 10 shows electrical connectors mated in an ECU according to some embodiments.
FIG. 11 shows one example mating an electrical connector in an ECU according to some embodiments.
FIG. 12 shows one example of an installed ECU according to some embodiments.
FIG. 13A shows one example of an ECU according to some embodiments.
FIG. 13B shows one example of an exploded view of an ECU according to some embodiments.
FIG. 14 shows one example of an electrical connector according to some embodiments.
FIG. 15 shows an exploded view of one example of an electrical connector according to some embodiments.
FIG. 16 shows one example of an ECU according to some embodiments.
FIG. 17A depicts one example of an electrical connector being robotically installed in an ECU according to some embodiments.
FIG. 17B depicts one example of multiple electrical connectors being robotically installed in an ECU according to some embodiments.
FIG. 17C depicts an exploded view of an ECU according to some embodiments.
FIG. 18 is a flow diagram that depicts one example of a method of installing an ECU according to some embodiments.

### DETAILED DESCRIPTION

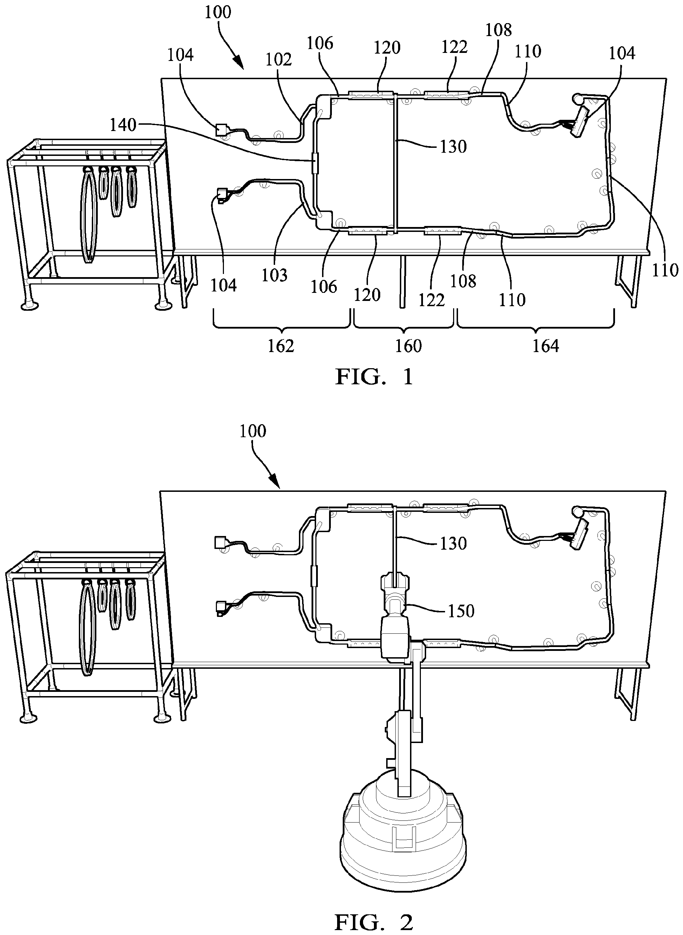

FIG. 1 is a diagram depicting a wiring harness 100 according to one or more embodiments. Wiring harness 100 is particularly suited to be robotically manipulated to perform one or more steps associated with installation of wiring harness 100 within a vehicle. For example, wiring harness 100 includes features that support robotic folding of harness 100. In other examples, wiring harness 100 includes features that support robotic unfolding of the wiring harness 100, and/or placement for installation within a vehicle. According to still other examples, wiring harness 100 includes features that may provide for robotically enabled coupling of connectors associated with the wiring harness 100 with corresponding connectors associated with other electrical systems or electrical system components of the vehicle.

As shown in FIG. 1, harness 100 includes at least a first cable 102 and a second cable 103. Cables 102, 103 carry one or more insulated conductors to distribute electrical power, signal, and or data between components of a vehicle electrical system or systems. In some examples, cables 102, 103 are decoupled from one another, as shown in the FIG. 1 example. In other examples, the first and second cables 102, 103 may be respective parts of continuous or electrically coupled conductors, with the first cable 102 being a portion of the cable arranged substantially parallel to the second cable 103 in an installation position in a vehicle.

As shown in FIG. 1, harness 100 includes a plurality of electrical connectors 104 that may be coupled to corresponding connectors associated with vehicle components and/or systems. The wiring harness 100 of FIG. 1 includes only three electrical connectors 104 for exemplary purposes. Wiring harness 100 may instead include a far greater number of electrical connectors than depicted in the FIG. 1 example.

Harness 100 depicted in FIG. 1 includes features to facilitate robotic installation in a vehicle. For example, as shown in FIG. 1, harness 100 includes a rigid gripping arm 130, a first pair of stiffeners 120, and a second pair of stiffeners 122. As shown in FIG. 1, harness 100 may be arranged to correspond to the contour of a body shape of a vehicle. For example, as shown in FIG. 1, rigid gripping arm 130 is mechanically coupled between the first and second cable portions 102, 103, and has a length that corresponds to a distance between a position of cable portions 102, 103 in a desired installation position in a vehicle. Rigid gripping arm 130 may be a rigid member configured to be securely grippable by a robotic actuator to manipulate harness 100, for example to fold or unfold harness 100, as well as to arrange harness 100 in an installation position in a vehicle, as described herein.

According to the example of FIG. 1, stiffeners 120, 122 define respective segments of harness 100, enabling harness 100 to be robotically folded and unfolded. As shown in FIG. 1, the stiffeners 120 are arranged at symmetrical positions along a length of cables 102 and 103, on a left side of rigid gripping arm 130, and have a length that defines a first side of segment 160, while stiffeners 122 are arranged at symmetrical positions along a length of cables 102 and 103, on a right side of rigid gripping arm 130, and have a length that defines a second side of segment 160.

Stiffeners 120, 122 operate to stiffen segment 160 so that it serves as a substantially rigid base for a robotic actuator to manipulate harness 100 via gripping arm 130 to fold or unfold harness 100. Accordingly, stiffeners 120, 122 may be formed of a length, and material, that along with a stiffness of cables 102, 103, defines and supports the segment 160 to be substantially rigid.

Stiffeners 120, 122 are further operable to define segments 162, 164 of the wiring harness 100 that are foldable, and respective folding points 106, 108 associated with the segments 162, 164. For example, as shown in FIG. 1, a leftmost end of stiffeners 120 defines segment 162 of the wiring harness 100, including a folding point 106 where segment 162 may be folded, while a rightmost end of stiffeners 122 defines segment 164 of the wiring harness 100, including a folding point 108 where segment 164 may be folded.

In some examples, stiffeners 120, 122 may be arranged at other locations along cables 102, 103 at positions relative to gripping member 130, to define each respective segment 160, 162, 164 to facilitate folding of the segments 162, 164. For example, as shown in the FIG. 1 example, stiffeners 120 may have a length selected such that segment 162 folds over segment 160, and stiffeners 122 may have a length selected such that segment 164 folds over segment 162 and segment 160.

In some examples, although not depicted in FIG. 1, stiffeners 120, 122 may further include one or more features that further define folding points 106, 108. For example, stiffeners 120, 122 may include one or more hinge mechanisms (not shown) that facilitate harness folding at folding points 106, 108 and/or define a range of motion of segments 162, 164 at folding points 106, 108.

As also shown in FIG. 1, harness 100 further includes a plurality of secondary stiffeners 110 arranged at positions along cables 102, 103. Secondary stiffeners 110 may be positioned along cables 102, 103 to increase a rigidity of the respective cables 102, 103, such that the respective segments 162, 164 are sufficiently rigid to be robotically folded.

In some embodiments, stiffeners 120, 122 and/or secondary stiffeners 110 may further serve as mounting features for securing harness 100 in position within a vehicle. For example, one or more of stiffeners 120, 122, 110 may be configured to mate with or otherwise be secured in position by one or more corresponding affixation mechanisms secured to a body of the vehicle.

In some optional embodiments, as also shown in FIG. 1, wiring harness 100 may include one or more cross-stiffeners that increase a rigidity of one or more of the segments 162, 164. For example, harness 100 depicted in FIG. 1 includes a cross-stiffener 140 mechanically coupled between the first and second cables 102, 103, to increase a rigidity of segment 162, to facilitate robotic folding. In other embodiments not depicted, more cross-stiffeners may be used, for example as part of segment 164.

As shown in the FIG. 1 example, cross-stiffener 140, like rigid gripping member 130, defines a distance between cables 102, 103 in a desired installation position within a vehicle. In some examples, dependent on placement in a vehicle and a contour of the vehicle, cross-stiffener 140 may have a length that defines a different distance between cables 102 than a distance defined by rigid gripping member 130, as shown in the example of FIG. 1.

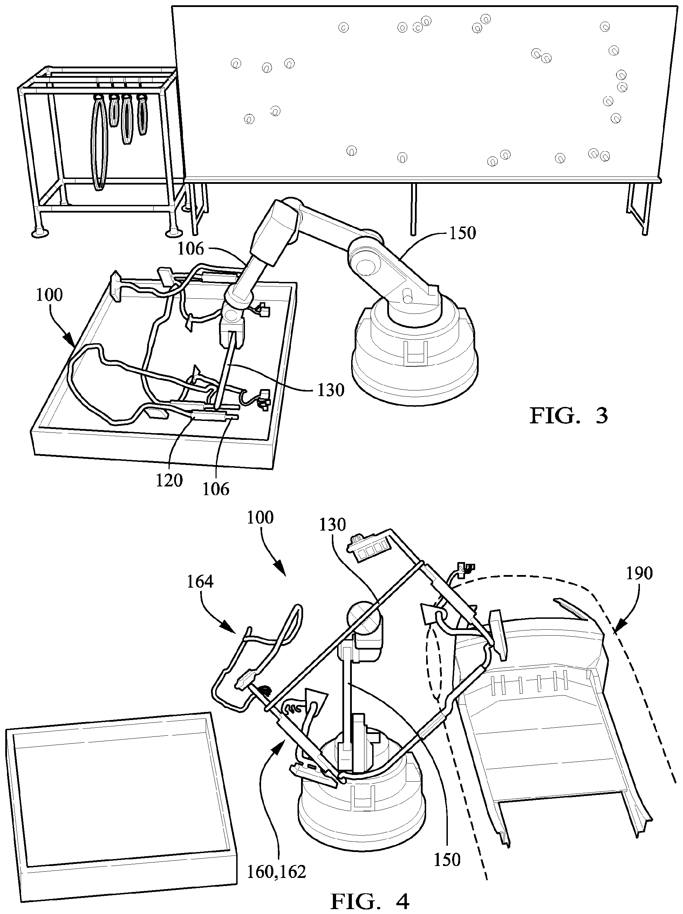

FIGS. 2-5 depict various examples of wiring harness 100 being manipulated by a robotic actuator according to some embodiments. FIG. 2 shows a robotic actuator 150 grabbing harness 100 from a vertical worksurface, via rigid gripping member 130. FIG. 3 shows harness 100 folded, after being manipulated by robotic actuator 150. Robotic actuator 150 may grip harness 100 via rigid gripping member 130, which supports segment 160 of harness 100. Robotic actuator 150 may position harness 100, via gripping member 130, into a position for segment 162 to be folded. Robotic actuator 150 may in a first motion, rotate harness 100 in a first direction with a force sufficient to cause the segment 162 to fold over segment 160 at folding point 106. Robotic actuator 150 may, in some examples, be configured to stop rotating at a predetermined angle that causes segment 162 to fold over segment 160. Robotic actuator 150 may, in a second motion, rotate harness 100 in a second direction with a force sufficient to cause segment 164 to fold over the segment 162 at the folding point 108, without causing the segment 162 to unfold from the segment 160. Robotic actuator 150 may, in some examples, be configured to stop rotating at a predetermined angle that causes segment 164 to fold over segment 162. As part of the second motion, actuator 150 may further place the folded harness 100 in a container for delivery to a customer. In this manner, harness 100 may be folded by robotic actuator 150 in preparation for shipment, as shown in FIG. 3.

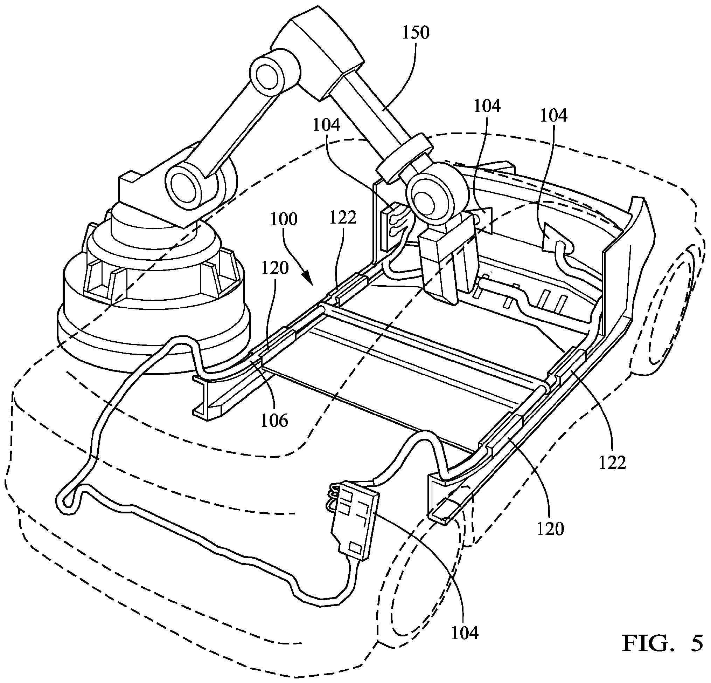

An actuator 150 may (e.g., at a vehicle manufacturer) grab, via gripping member 130, from a container that harness 100 was shipped in, the wiring harness 100 in a folded state, and manipulate the harness to unfold it, as shown in FIG. 4. For example, actuator 150 may, in a first motion, rotate harness in a first direction with a force sufficient to cause the segment 164 to unfold from the segment 162. Robotic actuator 150 may, in some examples, be configured to stop rotating at a predetermined position that causes segment 164 to unfold from segment 162. Actuator 150 may also, in a second motion following the first motion, rotate harness 100 in a second direction with a force sufficient to cause the segment 162 to unfold from segment 160. Robotic actuator 150 may, in some examples, be configured to stop rotating at a predetermined position that causes segment 162 to unfold from segment 160. In some examples, as part of the second motion, actuator 150 may further place the unfolded harness 100 in a desired mounting position within vehicle, as depicted in FIG. 5.

In some examples, harness 100 may be provided with instructions that enable a robotic actuator 150 to fold and/or unfold harness 100. For example, harness 100 may include instructions printed on one or more surfaces of harness 100 that indicate characteristics of harness 100 that the robotic actuator 150 may use to define a motion to fold or unfold the harness 100, or in other examples the harness 100 may include instructions executable by a robotic actuator to define the motion to fold or unfold harness 100. In some examples, the instructions may be computer-readable instructions, for example a bar code, QR code, or other printable pattern readable by one or more sensors associated with a computing system that controls the robotic actuator 150.

As some examples, instructions printed on a wiring harness may include one or more characteristics of the wiring harness, including: a position of the wiring harness within a vehicle, a size of the wiring harness, a length of cables 102, 103, a location, identity, or type of electrical connectors 104 associated with the wiring harness 100, a location or position of stiffeners 120, 122, 110 associated with the wiring harness 100, a weight associated with the wiring harness 100 and/or segments 160, 162, 164 of the wiring harness 100, a location of folding points 106, 108 defined on the wiring harness 100, an order by which segments 160, 162, 164 should be folded or unfolded, an angle or orientation at which a robotic actuator 150 should hold the wiring harness 100 (e.g., via gripping member 130), a velocity, force, or acceleration at which a robotic actuator 150 should move the wiring harness 100, and/or an angle or position at which the robotic actuator 150 should stop moving the wiring harness 100.

In some examples, the wiring harness 100 includes instructions specific to particular components or segments of the wiring harness. For example, harness 100 may include a first set of instructions associated with the stiffeners 120 and/or segment 162 of the wiring harness 100. The first set of instructions may be printed on or near the stiffeners 120 and include information associated with folding and unfolding segment 162 of the harness 100. Harness 100 may further include a second set of instructions associated with the stiffeners 122 and/or segment 164 of the wiring harness 100. The second set of instructions may be printed on or near the stiffeners 122 and include information associated with folding and unfolding the segment 164 of the harness 100.

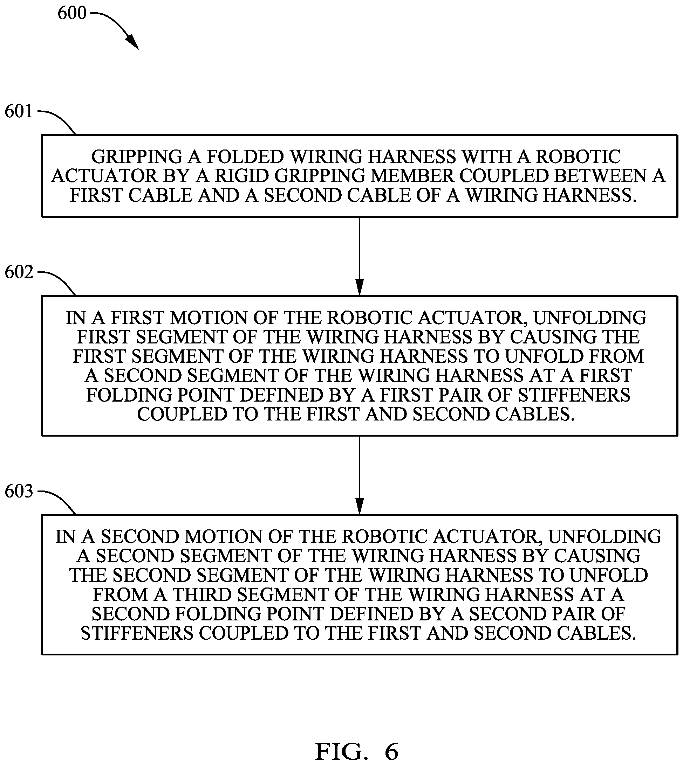

FIG. 6 is a flow diagram depicting one example of a method according to some embodiments. As shown in FIG. 6, at step 601 the method includes gripping, with a robotic actuator 150, a wiring harness by a rigid gripping member 130 coupled between a first cable 102 and a second cable 103 of a wiring harness 100. In some examples, the robotic actuator 150 has a length that corresponds to a distance between the first and second cables 102, 103 in an installation position of the wiring harness 100 in a vehicle.

As also shown in FIG. 6, the method further includes at step 602, in a first motion of the robotic actuator, unfolding a first segment 164 of the wiring harness by causing the first segment 164 to unfold from a second segment 162 at a first folding point 108 defined by a first pair of stiffeners 122 coupled to the first and second cables 102, 103. In some examples, causing the first segment 164 to unfold from the second segment 162 includes rotating the wiring harness 100 via the rigid gripping member 130 to cause the first segment 164 to unfold from the second segment 162.

As also shown in FIG. 6, the method further includes at step 603, in a second motion of the robotic actuator 150, unfolding the second segment 162 of the wiring harness 100 by causing the second segment 162 to unfold from a third segment 160 of the wiring harness 100 at a second folding point 106 defined by a second pair of stiffeners 120 coupled to the first and second cables 102, 103. In some examples, the second motion further includes placing the wiring harness 100 in a desired installation position within a vehicle.

The method of FIG. 6 may be applied as described above, with segment 164 as a first segment of the wiring harness 100 that unfolds at a first folding point 108, and a second segment 162 that unfolds at a second folding point 104. In other examples, the respective segments and folding points may be interchanged, for example where segment 162 is folded over segment 164 in a folded position of the wiring harness 100. According to these examples, the method includes, at 602, in a first motion of the robotic actuator, unfolding a first segment 162 of the wiring harness by causing the first segment 162 to unfold from a second segment 164 at a first folding point 104 defined by a first pair of stiffeners 120 coupled to the first and second cables 102, 103. At step 603, in a second motion of the robotic actuator 150, unfolding the second segment 164 of the wiring harness 100 by causing the second segment 164 to unfold from a third segment 160 of the wiring harness 100 at a second folding point 108 defined by a second pair of stiffeners 122 coupled to the first and second cables 102, 103.

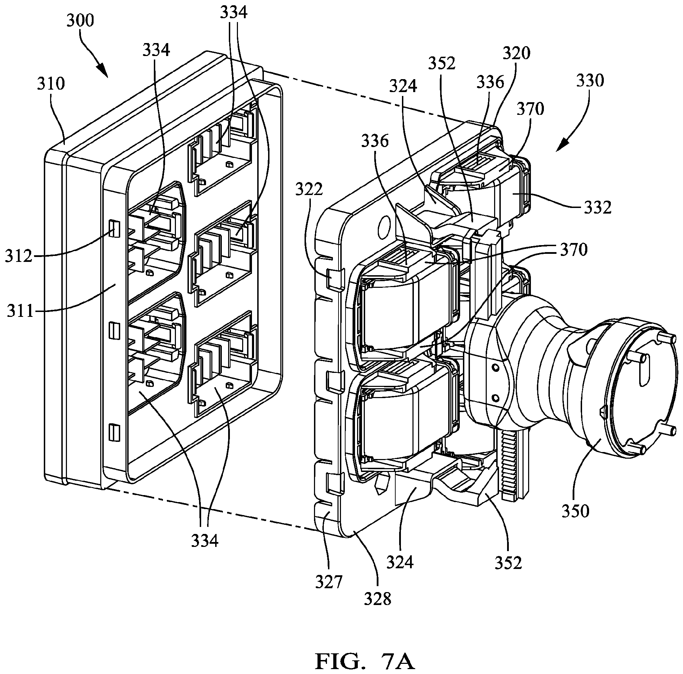

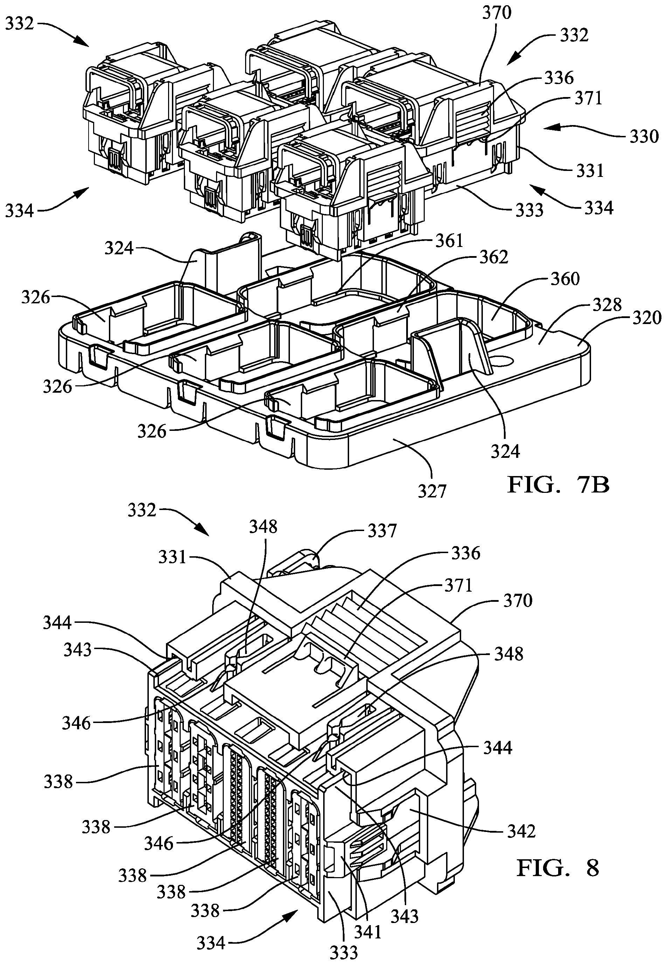

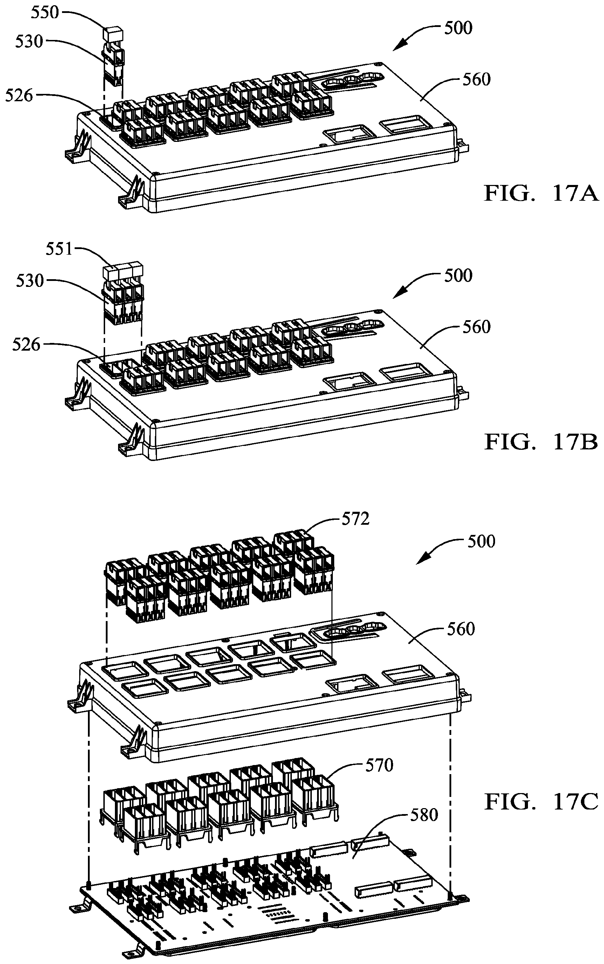

As shown in the examples of FIGS. 1-6 and discussed above, wiring harness 100 includes a plurality of connectors 104 that are used to couple conductors of the harness 100 to electrical components of systems of a vehicle. In some examples, connectors 104 may be traditional electrical connectors that facilitate manual coupling of the wiring harness 100 to electrical components of systems of a vehicle. In other examples, wiring harness 100 may also, or instead, incorporate more connector systems, such as an electronic connector unit connection system (ECU) that utilizes a carrier plate to carry a plurality of mating connector portions as depicted and described with respect to the examples of FIGS. 7-16. In still other examples, wiring harness 100 may incorporate connector portions that can be robotically mated through apertures formed in an ECU cover, as shown in FIGS. 17A-17C.

FIG. 7A depicts one example of an electronic control unit connection system (ECU) 300 suited for robotic installation in a vehicle according to some embodiments. FIG. 7B depicts an exploded view of ECU 300 according to some embodiments. As shown in FIG. 7A, ECU 300 includes a main body 310 that is mountable at a position within a vehicle interior, manually or otherwise. For example, main body 310 may be mounted on a vertical (e.g., wall panel) or horizontal (e.g., floor panel) surface associated with a vehicle. As shown in FIG. 7A, main body 310 includes a plurality of connector portions 334, each of which includes a plurality of terminals for mating therewith (not shown). According to the example of FIG. 7A, ECU 300 includes five connector portions 334, but may support more or fewer electrical connectors 330.

In some examples, ECU 300 may facilitate electrical connection to one or more electronic components carried within the ECU 300. For example, although not depicted in FIG. 7A, ECU 300 may house one or more circuit boards that include traces or other electrical conductors to couple one or more components, such as microprocessors, processors, graphics processing units (GPU), power management devices, or other components of vehicle electrical systems.

As shown in FIG. 7A, ECU 300 further includes a connector carrier plate 320. Carrier plate 320 is configured to carry a plurality of connector portions 332 that correspond to connector portions 334 of main body 310. In the example of FIG. 7A, connector portions 332, 334 may be mated together to form a plurality of electrical connectors 330 of the ECU 300. In the example of FIG. 7A, electrical connectors 330 may comprise header connectors of a vehicle electrical system.

In some embodiments, carrier plate 320 includes a planar surface 328 and a plurality of apertures 326 formed in the planar surface 328 to accommodate and carry the connector portions 332 in the carrier plate 320. For example, apertures 326 may be formed with a size and shape for connector portions 332 to snugly fit with apertures 326 such that connector portions 332 do not fall from carrier plate 320 when moved or otherwise manipulated as part of a vehicle manufacturing process.

In some examples, carrier plate 320 may include one or more features in apertures 326 that interact with corresponding features of connector portions 332 to hold the connector portions 332 in place when carrier plate 320 is manipulated, and also to allow connector portions 332 to be mated with connector portions 334 when carrier plate 320 is installed on main body 310. For example, as shown in the exploded view of FIG. 7B, each of apertures 326 includes a ledge 361 and a lip 362 formed on walls 360 of apertures 326. Lip 362 may interface with a corresponding ledge 371 on each of the connector portions 332 to define a staged position of the connector portions 332 when carrier plate 320 is secured to main body 310 (e.g., seated on flange 311), from which each electrical connector 330 can be mated and secured individually by robotic actuator 350. Ledge 361 may interface with each of the connector portions 332, for example a mate assurance module 331 of connector portions 332, to hold connector portions 332 in position while being manipulated by a robotic actuator 350, while allowing connector portions 332 to be moved in response to force applied to mate connector portions 332 and 334 to couple the electrical connectors 330. In some examples, ledge 361 and lip 362 may be arranged a distance apart that corresponds to a mating depth of connector portions 332, 334 relative to one another, allowing connector portion 332 to travel relative to connector portion 334 a distance sufficient to mate each electrical connector 330.

Carrier plate 320 is configured to be manipulated by a robotic actuator 350 to couple carrier plate 320 to main body 310, in order to facilitate mating of connector portions 332 and connector portions 334 to form a plurality of electrical connections of the ECU 300. For example, carrier plate 320 depicted in FIG. 7A includes a pair of robotic gripping features 324 and a rim 327 around a periphery of the planar surface 328. Rim 327 has a size and shape configured to interact with a flange 311 of main body 310, to define a seated position of and support carrier plate 320 on main body 310, to enable mating connection between connector portions 332 and 334. As also shown in FIG. 7A, rim 327 may further include a plurality of fastening features 322 that interact with corresponding fastening features 312 presented on flange 311 to secure carrier plate 320 in position on main body 310.

As shown in FIG. 7A, a robotic actuator 350 may manipulate carrier plate 320, e.g. via gripping features 324, to facilitate electrical connections via mating respective connector portions 332, 334 carried by carrier plate 320 and main body 310, respectively. In some examples, the respective connector portions 332 and 334 may be mated together by a pushing force applied to the connector portions 332, for example by a robotic actuator applying a force at one or more gripping surfaces \336 presented on the connector portions 332.

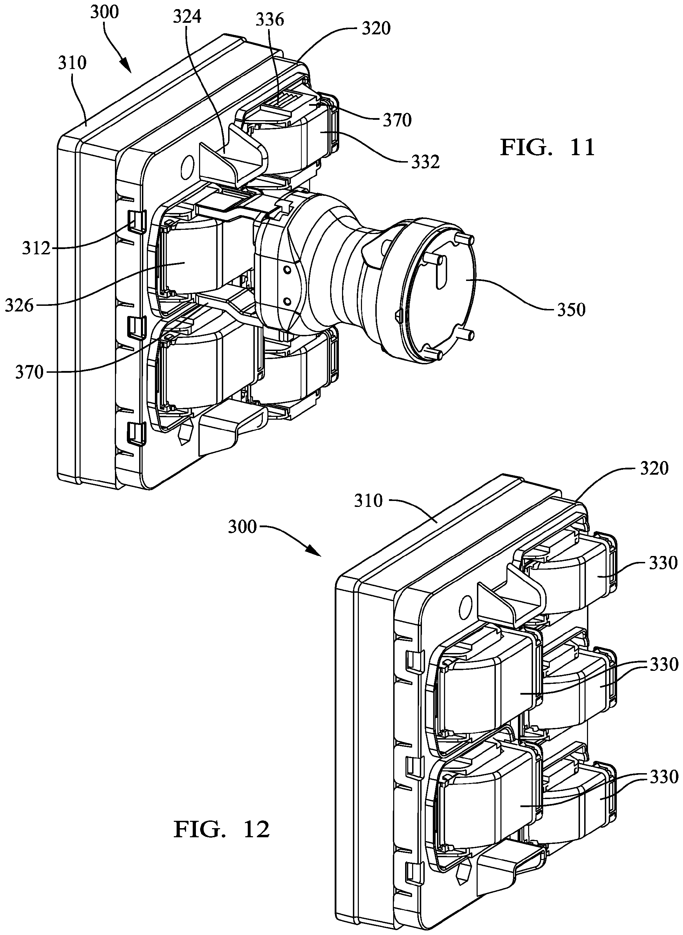

In some examples, flange 311 and rim 327 may each have a height that corresponds to a relative depth between connector portions 332 and 334 that corresponds to a staged position of the electrical connectors 330, such that a robotic actuator may then mate and secure each electrical connector 330 sequentially as shown in the example of FIG. 11 and described in further detail herein.

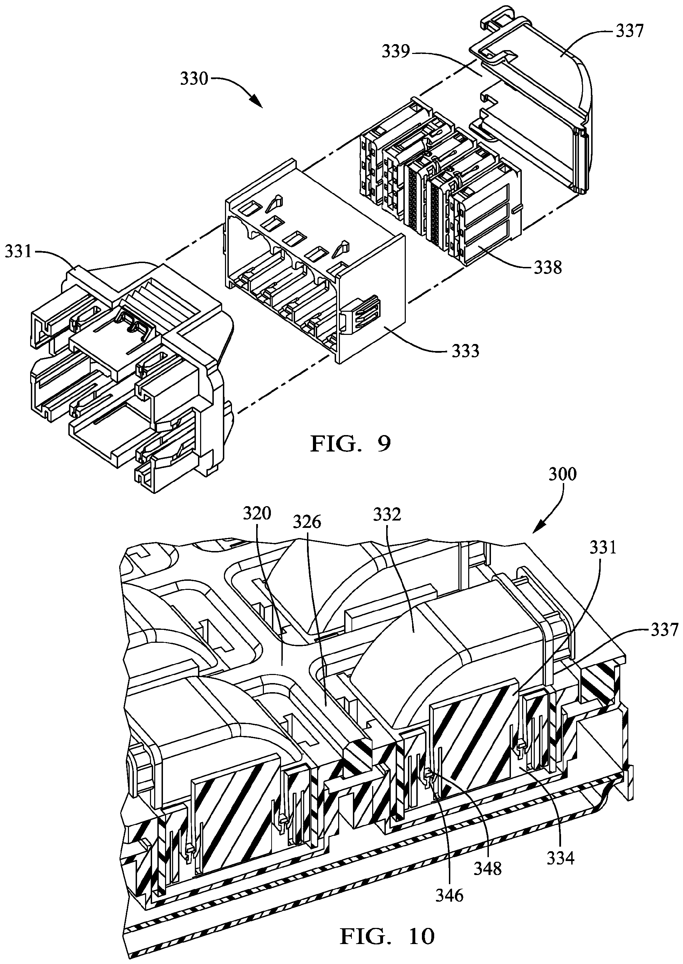

FIG. 8 depicts an electrical connector 330, which may be used as part of an ECU, for example ECU 300 depicted in FIG. 7. FIG. 9 is an exploded view of electrical connector 330, according to some embodiments. As shown in FIG. 9, electrical connector 330 includes a connector housing 333, a mate assurance module 331, a dress cover 337, and a plurality of terminal modules 338. FIG. 10 shows electrical connectors 330 in a mated position in an ECU, according to some embodiments.

Electrical connector 330 includes connector portions 332, 334 that, when mated together, establish a plurality of electrical connections within the electrical connector 330 via terminals carried by the respective connector portions 332, 334. For example, connector portion 334, including connector housing 333 may be securely mounted, for example at an exposed surface of an ECU 300 main body 310, and may carry a first plurality of mating terminals (not shown) of the terminal modules 338. Connector portion 332, including mate assurance module 331 and dress cover 337, may carry a second plurality of mating terminals (not shown) of the terminal modules 338 coupled to one or more cables associated with vehicle electrical systems, such as cables of a wiring harness 100 as depicted in FIG. 1. The example of FIG. 8 shows electrical connector 330 in a staged position, prepared for the respective first and second connector portions 332, 334 to be mated, thereby establishing a plurality of electrical connections within electrical connector 330.

In some examples, terminal modules 338 may be modular terminal modules in the sense that they may include a range of different terminals specific to a particular application or group of applications. For example, a first terminal module may be configured to support coupling of high-speed data conductors, such as a coaxial cable terminals. In some examples, a second terminal module may be configured to support coupling of automotive signal cables (e.g., a CAN bus or the like). In some examples, a particular terminal module 338 may be used repeatedly within one connector 330 and/or may be used across multiple connectors 330 of the ECU 300.

As shown in FIG. 8, electrical connector 330 includes a plurality of alignment features that align the connector housing 333 and mate assurance module 331 together in a staged position of electrical connector 330. For example, housing 333 includes alignment features 341 presented on a first side of the housing 333 which interface with a track 342 defined in the mate assurance module 331, and alignment features 343 presented on a second side of the housing 333 which interface with slots 344 defined in the mate assurance module 331 to define a lateral positioning of mate assurance module 331 relative to housing 333. In some examples, alignment features 341 are configured to interact with corresponding features of mate assurance module 331 to define a mated position of mate assurance module 331 relative to connector housing 333 and, in some examples, operate as a supplemental lock along with locking features 346, 348 described below.

As shown in FIG. 8, electrical connector 330 includes a plurality of push surfaces 370 on an upper surface of each mate assurance module 331, that are each configured to be pushed by a robotic actuator 350 to mate the respective connector portions 332, 334, to lock each connector 330 in place. As also shown in the FIG. 8 example, connector 330 may optionally include one or more gripping surfaces 336, which may be grippable by robotic fingers to push connector portions 332, 334 together to mate each electrical connector 330, instead of push surfaces 370.

As shown in FIG. 8, electrical connector 330 further includes lock features that enable connector 330, including respective terminals carried by the respective connector portions 332, 334, to be mated and locked in a secure position based on a force applied to the mate assurance module 331, such as a force applied by a robotic actuator 350. For example, connector housing 333 includes lock feature 346 which corresponds with lock feature 348 of mate assurance module 331, which are configured to lock together in response to sufficient force applied to the mate assurance module 331. As shown in FIG. 8, the lock feature of mate assurance module 331 comprises a pair of prongs 348 arranged close together, and the lock feature of connector housing 333 comprises a stop 346 that supports the prongs 348 in a staged position of connector 330. For example, as shown in FIG. 8, prongs 348 are resting upon stop 346 in the staged position.

To mate the respective connector portions 332, 334, when aligned in a staged position as shown in FIG. 8, a force may be applied, by a human or machine operator, upon mate assurance module 331 towards connector housing 333. In response to such a force, prongs 348 may be separated by stops 346, allowing the prongs 348 to pass stops 336. Once prongs 348 have passed stops 346, the prongs 348 return to their original position and are blocked by the stops 346 such that connector portion 332 is prevented from releasing from connector portion 334. In this manner, connector 330 may be locked with a push force applied to connector portion 332 against connector portion 334.

In some examples, prongs 348 and stop 346 may be arranged such that connector 330 may be unlocked in response to a second push force applied to the mate assurance module 331, which is quickly released. According to these examples, prongs 348 are configured such that further compressing mate assurance module 331 towards housing 333 causes prongs 348 to separate enough such that if the second push force upon mate assurance module 331 is quickly released, prongs 348 may pass stops 346 before prongs 348 come together enough to lock connector 330, thereby unlocking connector 330.

Referring back to the example of FIG. 7, in order to mate ECU 300, a robotic actuator 350 may grab a connector carrier plate 320, for example via gripping features 324 presented on the carrier plate 320. The carrier plate 320 may carry a plurality of connector portions 332, each configured to mate with corresponding connector portions 334 of an ECU main body 310 mounted to a surface of a vehicle. The connector portions 332 may each carry one or more electrical cables routed through an aperture 339 in a dress cover 337 that terminate in one or more terminals carried by the terminal modules 338.

According to the FIG. 7 example, a robotic actuator 350 may align the carrier plate 320 with the main body 310, and secure the carrier plate 320 to the main body 310 in a seated position by pushing the carrier plate 320 against the main body 310. For example, the robotic actuator 350 may align a rim 327 of the carrier plate 320 with a flange 311 of the main body 310, and push the carrier plate 320 against the main body 310 such that the rim 327 receives the flange 311. In some examples, pushing the carrier plate 320 against the main body 310 further causes respective locking features 312, 322 of the flange 311 and rim 327 to engage to secure a position of the carrier plate 320 relative to the main body 310.

In some examples, the carrier plate 320 and main body 310 are configured such that when secured together as described above, the respective connector portions 332, 334 of electrical connectors 330 are brought into alignment in a staged position, e.g., as shown in the example of FIGS 8, where the respective connector portions 332, 334 are seated and aligned in position to be mated, including bringing terminals carried by the respective connector portions 332, 334 into alignment for mating.

According to the FIG. 12 example, ECU 300 is configured such that a robotic actuator 350 sequentially mates each electrical connector 330 of the ECU 300. For example, as shown in the example of FIG. 11, once carrier plate 320 is seated and secured in position on main body 310, a robotic actuator 350 may push each of connector portions 332 (e.g., via gripping surfaces 336 or push features 370), and mate each connector 330 by applying a force to urge connector portion 332 towards connector portion 334, thereby mating the connector terminals and locking each connector 330. According to this example, the robotic actuator 350 may individually mate each of connectors 330 until all connectors 330 of the ECU 300 have been mated. In some examples, ECU 300 may be considered installed once each connector 330 has been mated, as shown in the example of FIG. 12. In other examples, a human or robotic operator may secure a cover (not shown) over the ECU 300 to install the ECU 300.

In some examples, carrier plate 320 may be configured such that mating electrical connectors 330 through carrier plate 320 further secures carrier plate 320 in place on main body 310. For example, apertures 326 may further be formed with a ledge 361 presented at a depth that corresponds to a locked position of the connectors 330. According to these examples, when each connector 330 is mated and locked within the aperture 326, the ledge 361 is sandwiched between connector portion 332 (e.g., mate assurance module 331) and connector portion 334, thereby further securing the carrier plate 320 in place on main body 310.

FIGS. 7-12 depict an ECU 300 particularly suited to being automatically installed in a vehicle by a robotic actuator 350. According to these examples, a wiring harness such as wiring harness 100 depicted in FIG 1, may include one or more ECU carrier plates 320 that each carry a plurality of connector portions 332 connected with wiring of the harness 100. One or more robotic actuators 150, 350 may install the harness 100 in the vehicle, including mating the connector portions 332 with corresponding connector portions 334 carried by a main body 310 of the ECU 300 mounted in the vehicle. According to this example, the robotic actuator 350 may secure the carrier plate 320 to the main body 310, thereby aligning the plurality of connector portions 332 with the plurality of connector portions 334 in a staged position wherein the connectors 330 are prepared to be mated and locked. The robotic actuator 350 may then mate each connector 330 of the ECU 300 individually, for example, by applying a force to one or more gripping surfaces 336 or push surfaces 370 of each of the connectors 330. In this manner, ECU 300 is particularly suited to robotic installation within a vehicle, thereby reducing an amount of manual effort needed to install a vehicle electrical system.

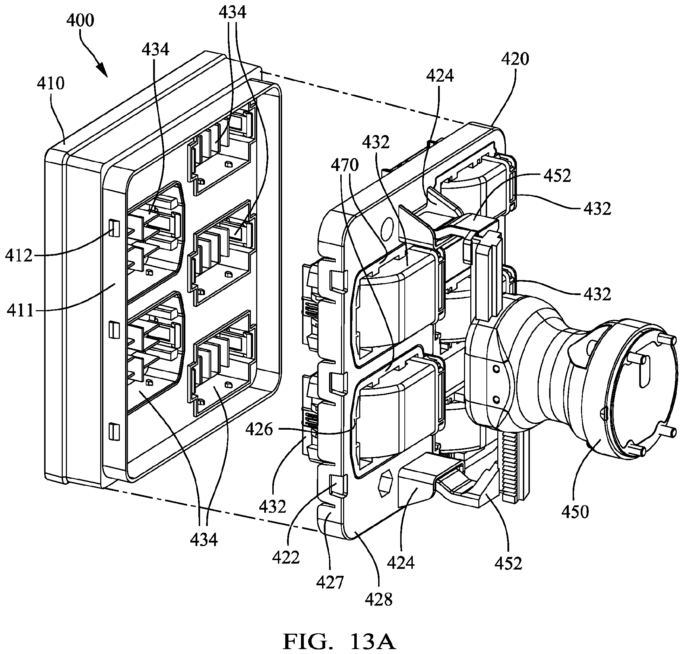

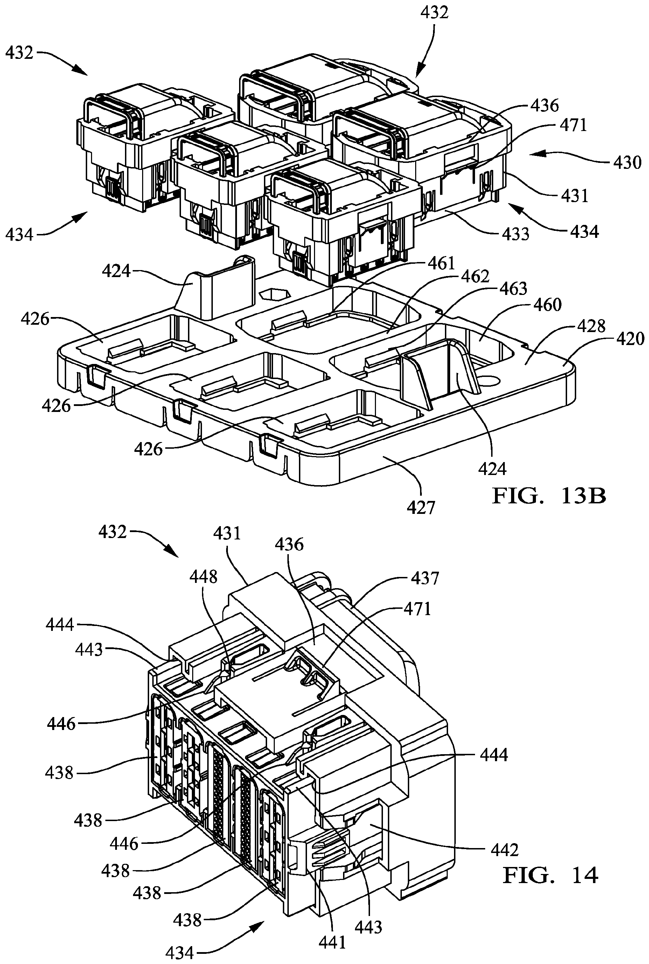

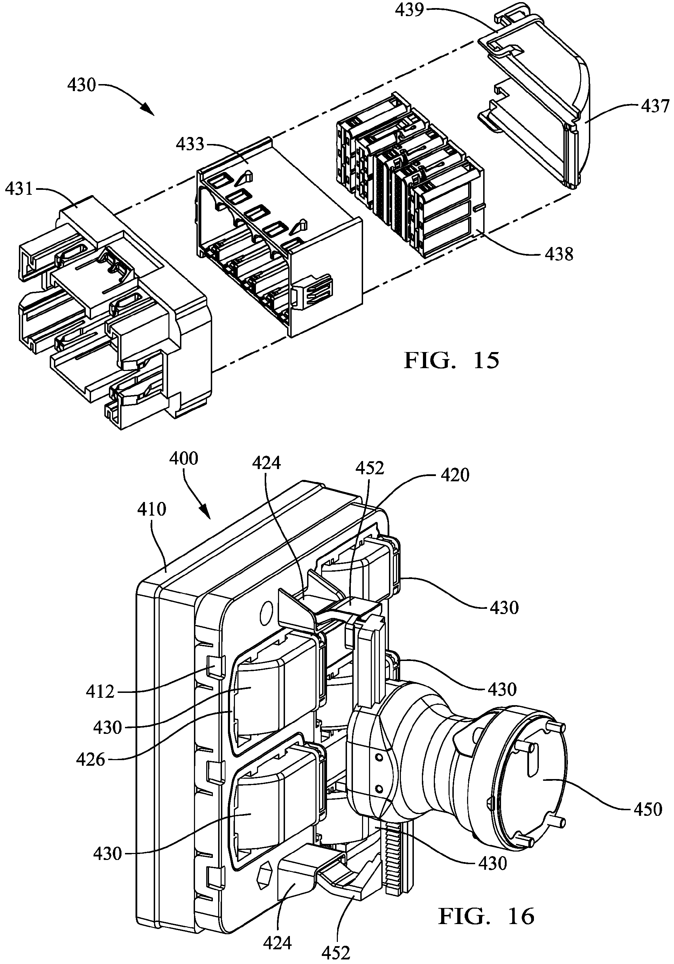

FIG. 13A depicts one example of an ECU 400 according to some embodiments. FIG. 13B depicts an exploded view of ECU 400 according to some embodiments. FIG. 16 depicts one example of ECU 400 installed in a vehicle according to some embodiments. ECU 400 differs from ECU 300 in that it includes a carrier plate 420 that carries a plurality of connector portions 432 adapted to be mated simultaneously by mounting the carrier plate 420 onto the main body 410.

As shown in FIG. 13A, ECU 400 includes a main body 410 that is mountable at a position within a vehicle interior, manually or otherwise. For example, main body 410 may be mounted on a vertical (e.g., wall panel) or horizontal (e.g., floor panel) surface associated with a vehicle. As shown in FIG. 13A, main body 410 includes a plurality of connector portions 434, each of which includes a plurality of terminals (not shown) for mating therewith. According to the example of FIG. 14, main body 410 includes five connector portions 434, other examples may include more or fewer connector portions 434.

In some examples, ECU 400 may facilitate electrical connection to one or more electronic components carried within the ECU 400. For example, although not depicted in FIG. 13, ECU 400 may house one or more circuit boards that include traces or other electrical conductors to couple one or more components, such as microprocessors, processors, graphics processing units (GPU), power management devices, or other components of vehicle electrical systems.

As shown in FIG. 13A, ECU 400 further includes a connector carrier plate 420. Carrier plate 420 is configured to carry a plurality of connector portions 432 that correspond to connector portions 434 of main body 410. Carrier plate 420 includes planar surface 428 and a plurality of apertures 426 formed in the planar surface 428 to accommodate and secure the connector portions 432 in the carrier plate 420. For example, apertures 426 may be formed with a size and shape for connector portions 432 to fit with apertures 426 such that connector portions 432 do not fall from carrier plate 420 when moved or otherwise manipulated as part of a vehicle manufacturing process.

In some examples, carrier plate 420 includes one or more features in apertures 426 that interact with corresponding features of connector portions 432 to hold the connector portions 432 in place when carrier plate 420 is manipulated, as well as to secure the connector portions 432 in position to be simultaneously mated when the carrier plate 420 is installed on the main body 410. For example, as shown in the exploded view of FIG. 13B, each of apertures 426 includes a ledge 461 and a lip 462 formed in a wall 460 of apertures 426. Lip 462 may interface with a corresponding ledge 471 on each of the connector portions 432 to define a mated position of the connector portions 432 relative to connector portions 434 when carrier plate 420 is secured to main body 410 (e.g., seated on flange 411), from which the connectors 430 can be simultaneously mated. Ledge 463 may interface with each of connector portions 432, for example a mate assurance module 431 of connector portions 432, to hold connector portions 432 in position while being manipulated by a robotic actuator. In some examples, ledge 461 and lip 462 may operate together to securely hold connector portions 432 at a depth that corresponds to a mated position relative to connector portions 434 such that connector portions 432 do not travel and are mated when carrier plate 420 is seated on main body 410.

In some examples, flange 411 and rim 427 may each have a height that corresponds to a relative depth between the respective connector portions 432 and 434 that defines a mated position of the connectors 430, such that a robotic actuator may simultaneously mate connectors 430 at one time by seating the carrier plate 420 on the main body 410, as shown in the example of FIG. 13A.

FIG. 14 depicts an electrical connector 430, which may be used as part of an ECU, for example ECU 400 depicted in FIG. 13. FIG. 15 is an exploded view of connector 430, according to some embodiments. As shown in FIG. 14, connector 430 includes a connector housing 433, a mate assurance module 431, a dress cover 437, and a plurality of terminal modules 438, which are shown mated together in the FIG. 14 example.

Electrical connector 430 includes connector portions 432, 434 that, when mated together, establish a plurality of electrical connections within the connector 430 via terminals carried by the respective connector portions 432, 434. For example, connector portion 434, including connector housing 433 may be securely mounted, for example at an exposed surface of an ECU 400 main body 410, and may carry a first plurality of mating terminals (not shown) of the terminal modules 438. Connector portion 432, including mate assurance module 431 and dress cover 437, carries a second plurality of mating terminals (not shown) of the terminal modules 438 coupled to one or more cables associated with vehicle electrical systems, such as cables of a wiring harness 100 as depicted in FIG. 1. The example of FIG. 14 shows electrical connector 430 in a staged position, prepared for the respective first and second connector portions 432, 434 to be mated, thereby establishing a plurality of electrical connections within connector 430.

In some examples, terminal modules 438 may be modular terminal modules in the sense that they may include a range of different terminals specific to a particular application or group of applications. For example, a first terminal module 438 may be configured to support coupling of high-speed data conductors, such as a coaxial cable terminals. In some examples, a second terminal module 438 may be configured to support coupling of automotive signal cables (e.g., a CAN bus or the like). A particular module 438 may be used repeatedly within one connector 430 and/or may be used across multiple connectors 430 of the ECU.

As shown in FIG. 14, electrical connector 430 includes a plurality of alignment features that align the connector housing 433 and mate assurance module 431 together in a staged position of connector 430. For example, housing 433 includes alignment features 441 presented on a first side of the housing 433 which interface with a track 442 defined in the mate assurance module 431, and alignment features 443 presented on a second side of the housing 433 which interface with slots 444 of the mate assurance module 431 to define a lateral positioning of mate assurance module 431 relative to housing 433. In some examples, alignment features 441 are configured to interact with corresponding features (not shown) of mate assurance module 431 to define a mated position of mate assurance module 431 relative to connector housing 433 and, in some examples, operate as a supplemental lock along with locking features 446, 448 described below.

As shown in FIG. 14, electrical connector 430 further includes lock features that enable connector 430, including respective terminals carried by the respective connector portions 432, 434, to be mated and locked in a secure position based on a force applied to the mate assurance module 431 via the carrier plate 420, such as a force applied by a robotic actuator. For example, connector housing 433 includes lock feature 446 which corresponds with lock feature 448 of mate assurance module 431, which are configured to lock together in response to sufficient force applied to the mate assurance module 431 via the carrier plate 420. As shown in FIG. 14, the lock feature of the mate assurance module 431 comprises a pair of prongs 448 arranged close together, and the lock feature of the connector housing 433 comprises a stop 446 that supports the prongs 448 in a staged position of connector 430. For example, as shown in FIG. 14, prongs 448 are resting upon stop 446 in the staged position.

To mate the respective connector portions 432, 434, a force may be applied, by a human or machine operator, upon mate assurance module 431 via the carrier plate 420 towards connector housing 433. In response to such a force, prongs 448 may be separated by stops 446, allowing the prongs 448 to pass stops 446. Once prongs 448 have passed stops 446, the prongs 448 return to their original position and are blocked by the stops 446 such that connector portion 432 is prevented from releasing from connector portion 434. In this manner, connector 430 may be locked with a push force applied via the carrier plate 420 to connector portion 432 against connector portion 434.

In some examples, prongs 448 and stops 446 may be arranged such that connector 430 may be unlocked in response to a second push force applied to the mate assurance module 431, which is quickly released by the operator. According to these examples, prongs 448 are configured such that further compressing mate assurance module 431 towards housing 433 causes prongs 448 to separate enough such that if the force upon mate assurance module 431 is quickly released, prongs 448 may pass stops 446 before prongs 448 come together enough to lock connector 430, thereby unlocking connector 430. According to these examples, prongs 448 and stops 446 may be unmated by applying a force to carrier plate 420, to simultaneously release the connectors 400 from the locked position.

As also shown in the example of FIG. 14, connector portion 432 further includes a ledge 471 on an exterior of mate assurance module 431. Ledge 471 is configured to interface with lip 462 within apertures 426 to secure a position of connector portions 432 such that connectors 430 are simultaneously mated by securing the carrier plate 420 to the main body 410. For example, ledge 471 may present a force opposing to a mating direction of connector 430, such that connectors 430 may be mated by securing carrier plate 420 to main body 410 as described herein.

Carrier plate 420 is configured to be manipulated by a robotic actuator 450 to couple carrier plate 420 to main body 410, in order to facilitate mating of connector portions 432 and 434 to establish a plurality of electrical connections of the ECU 400. For example, carrier plate 420 depicted in FIG. 13A includes a pair of robotic gripping features 424 and a rim 427 around a periphery of the planar surface 428. Rim 427 has a size and shape configured to interact with a flange 411 of main body 410, to define a position of and support carrier plate 420 on main body 410 to enable mating connection between connector portions 432, 434. As also shown in FIG. 13A, rim 427 may further include a plurality of fastening features 422 that interact with corresponding fastening features 412 presented on flange 411 to secure carrier plate 420 in position on main body 410.

As shown in FIG. 13A, a robotic actuator 450 may manipulate carrier plate 420, e.g. via gripping features 424, to facilitate electrical connections via mating respective connector portions 432, 434 carried by carrier plate 420 and main body 410, respectively. In some examples, the respective connector portions 432 and 434 may be mated together by a pushing force applied to the carrier plate 420, for example by a robotic actuator 450 (e.g., via gripping fingers 452), by applying a force at robotic gripping features 424 of the carrier plate 420, as shown in FIG. 16.

In some examples, flange 411 and rim 427 may each have a height that corresponds to a relative depth between connector portions 432 and 434 that defines a mated and/or locked position of electrical connectors 430, such that a robotic actuator 450 can mate and secure each connector 430 simultaneously in response to force applied on carrier plate 420, as shown in the example of FIG. 16. In some examples, carrier plate 420 may be gripped by a robotic actuator 450, and positioned in alignment with main body 410 (e.g, with rim 427 aligned with flange 411). According to some examples, the robotic actuator 450 may first align connector portions 432 and insert them into connector portions 434 in a staged position (e.g., such that prongs 448 rest on stops 446 in the FIG. 14 example) in a first motion, and in a second motion, push carrier plate 420 into main body 410 to secure the carrier plate 420 to the main body 410 and thereby lock the connectors 430 (e.g., by causing prongs 448 to pass stops 446 in the FIG. 16 example). In other examples, ECU 400 may be configured such that a robotic actuator 450 stages and mates electrical connectors 430 in a single motion. According to these examples, the robotic actuator 450 may align carrier plate 420 with main body 410, thereby aligning connector portions 432, 434 for mating, and in a single motion lock the connectors 430 (e.g., by causing prongs 448 to pass stops 446 in the FIG. 16 example).

In some examples, a human or robotic operator may further secure a cover (not shown) over the ECU 400 once the carrier plate 420 has been installed on the main body 410. In other examples not depicted, carrier plate 420 may be provided with connector portions 432 arranged within carrier plate 420 and covered by a cover (not shown). According to these examples, the cover may include robotic gripping features that a robot can manipulate to install the cover, and thereby the carrier plate 420 on the main body 310, thereby mating each of the electrical connectors 430 as described above.

FIGS. 13-16 depict an ECU 400 particularly suited to being automatically installed in a vehicle by a robotic actuator. According to these examples, a wiring harness such as wiring harness 100 depicted in FIG 1, may include one or more ECU carrier plates 420 that each carry a plurality of connector portions 432 connected with wiring of the harness 100. One or more robotic actuators 150, 450 may install the harness 100 in the vehicle, including mating the connector portions 432 with corresponding connector portions 434 carried by a main body 410 of the ECU 400 mounted in the vehicle. According to this example, the robotic actuator 450 may secure the carrier plate 420 to the main body 410, thereby mating the plurality of connector portions 432 with the plurality of connector portions 434. In this manner, ECU 400 is particularly suited to robotic installation within a vehicle by enabling the ECU 400 to be robotically mounted in a vehicle in a single step, thereby reducing an amount of manual effort needed to install a vehicle electrical system.

FIGS. 17A-17C depict one example of an ECU 500 according to some embodiments. ECU 500 may be suited for robotic installation in a vehicle in some embodiments. FIG. 17A depicts an example ECU 500 that includes a plurality of electrical connectors 530 installable by a robotic actuator 550 through an aperture 526 in the ECU cover 560 according to some embodiments. FIG. 17B depicts the ECU 500 with a robotic actuator 551 simultaneously installing a plurality of electrical connectors 530 in some embodiments. FIG. 17C is an exploded view showing components of ECU 500 according to some embodiments.

As shown in the example of FIGS. 17A-17C, ECU 500 includes a PCB 580 including a pin block enabling electrical connection to components of the PCB (e.g., processor, communications, or other circuitry). A plurality of first connector portions 570 are arranged on the PCB, at least some of which are electrically coupled to the pin blocks. A cover 560 covers the PCB and the first connector portions 570, and includes a plurality of apertures 526 that correspond to the plurality of first connector portions 570. A plurality of second connector portions 572 may be coupled with the first connector portions 570 through the apertures 526. For example, each second connector portion 572 may be individually gripped by a robotic actuator 550, and coupled to a corresponding first connector portion 570 through the aperture 526, as shown in FIG. 17A. In other examples, multiple second connector portions 572 may be grabbed by a robotic actuator 551, and mated simultaneously with first connector portions 570 through the apertures 526, as shown in FIG. 17B.

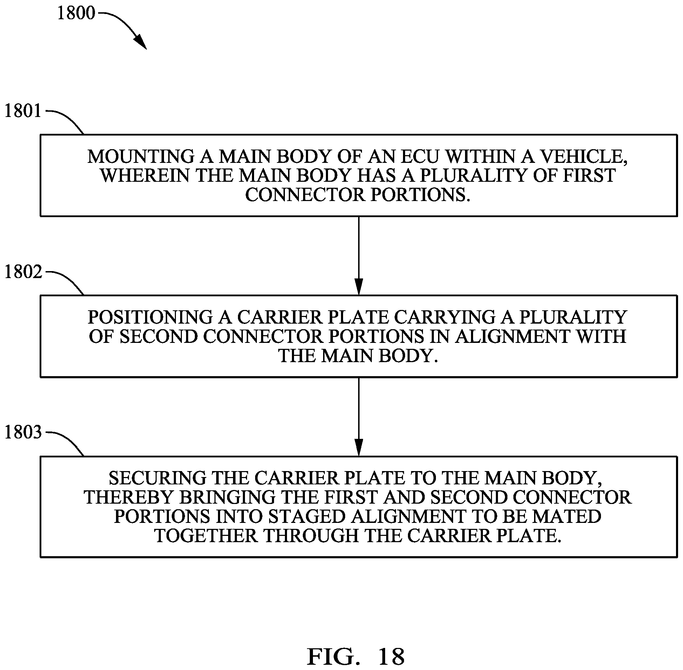

FIG. 18 is a flow diagram that depicts one example of a method of installing an electronic control unit connection system (ECU) (300, 400, 500) in a vehicle that may include steps performed by a robotic actuator (350, 450, 550, 551). At step 1801, the method includes mounting a main body (310, 410) of the ECU within the vehicle, wherein the main body has a plurality of first connector portions (334, 434, 570). At step 1802, the method further includes positioning a carrier plate (320, 420) carrying a plurality of second connector portions (332, 432) in alignment with the main body. At step 1803, the method further includes securing the carrier plate to the main body, thereby bringing the first and second connector portions into staged alignment to be mated together through the carrier plate. In some examples, the method further includes sequentially mating each of the first and second plurality of connector portions to form a plurality of electrical connectors (330) of the ECU (300). In other examples, the method further includes simultaneously mating the first and second plurality of connector portions to form a plurality of electrical connectors (430) by securing the carrier plate to the main body.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A wiring harness for robotic installation in a vehicle, comprising:
a first cable and a second cable that each carry electrical conductors in the form of wiring;
a plurality of stiffeners that define one or more folding points of the wiring harness; and
a rigid gripping member mechanically coupled between the first and second cables to define a distance, wherein the rigid gripping member is configured to be grabbable by a robotic arm and manipulated to fold and unfold the wiring harness at the folding points defined by the plurality of stiffeners.

2. The wiring harness of claim 1, wherein the distance corresponds to a width between the first and second cables in an installation position within a body of the vehicle.

3. The wiring harness of any of claims 1-2, wherein the plurality of stiffeners comprise a first pair of stiffeners symmetrically arranged at a first position along a length of the first and second cables to define a first folding point, and a second pair of stiffeners symmetrically arranged at a second position along a length of the first and second cables to define a second folding point different than the first folding point.

4. The wiring harness of any of claims 1-3, further comprising instructions that enable a robotic actuator to fold or unfold the wiring harness.

5. The wiring harness of any of claims 1-4, wherein the instructions cause a robot actuator to, in a first motion, cause a first segment of the wiring harness to unfold from a second segment of the wiring harness, and in a second motion, unfold the second segment from a third segment of the wiring harness and arrange the wiring harness in a defined position within the vehicle.

6. The wiring harness of any of claims 1-5, wherein the instructions cause a robot actuator to, in a third motion, cause the second segment of the wiring harness to fold over third segment of the wiring harness, and in a fourth motion cause the first segment of the wiring harness to fold over the second and third segments of the wiring harness.

7. The wiring harness of any of claims 1-6, wherein the instructions comprise machine-readable instructions located on at least one surface of the wiring harness.

8. The wiring harness of any of claims 1-7, further comprising:
first machine-readable instructions printed on at least one of the first pair of stiffeners that define a first motion associated with a first segment of the wiring harness; and
second machine-readable instructions printed on at least one of the second pair of stiffeners that define a second motion associated with a second segment of the wiring harness.

9. The wiring harness any of claims 1-8, wherein the instructions define one or more characteristics associated with robotic manipulation of the wiring harness selected from the group consisting of:
a position of the wiring harness within a vehicle;
a size of the wiring harness;
a location of the plurality of stiffeners along a length of the first and second cables;
a length of the first and second cables;
a location, identity, and/or type and of electrical connectors associated with the wiring harness;
a location or position of stiffeners associated with the wiring harness;
a weight associated with the wiring harness;
a location of folding points defined on the wiring harness;
an identification of folding segments of the wiring harness;
an order by which the folding segments should be folded or unfolded;
an angle or orientation at which a robotic actuator should hold the wiring harness;
a velocity, force, or acceleration at which a robotic actuator should move the wiring harness; and
an angle or position at which the robotic actuator should stop moving the wiring harness.

10. The wiring harness any of claims 1-9, wherein the rigid gripping member is a first cross-stiffening member mechanically coupled between the first and second cables at a first position along a length of the first and second cables and defines the distance as a first distance, and further comprising:
at least a second cross-stiffening member mechanically coupled between the first and second cables and configured to define a second distance.

11. The wiring harness of claim any of claims 1-10, wherein the second distance is different than the first distance.

12. The wiring harness of any of claims 1-11, further comprising a carrier plate coupled to the wiring harness, wherein the carrier plate carries a plurality of first connector portions configured to be mated with a corresponding plurality of second connector portions of a main body to form a plurality of electrical connectors of an electronic control unit connection system (ECU).

13. The wiring harness of any of claims 1-12, wherein the ECU is installed by coupling the carrier plate to the main body to define a staged position of the plurality of electrical connectors, and sequentially mating each of the plurality of electrical connectors.

14. The wiring harness any of claims 1-13, wherein the ECU is installed by coupling the carrier plate to the main body to define a staged position of the plurality of electrical connectors, and simultaneously mating each of the plurality of electrical connectors.

15. A method comprising:
gripping a folded wiring harness with a robotic actuator by a rigid gripping member coupled between a first cable and a second cable of a wiring harness;
in a first motion of the robotic actuator, unfolding a first segment of the wiring harness by causing the first segment of the wiring harness to unfold from a second segment of the wiring harness at a first folding point defined by a first pair of stiffeners coupled to the first and second cables; and
in a second motion of the robotic actuator, unfolding a second segment of the wiring harness by causing the second segment of the wiring harness to unfold from a third segment of the wiring harness at a second folding point defined by a second pair of stiffeners coupled to the first and second cable.
